# EUROPEAN PATENT SPECIFICATION

(11) **EP 4 001 491 B1**
(45) Date of publication and mention of the grant of the patent: **02.08.2023**
(21) Application number: 21205136.1
(22) Date of filing: 28.10.2021
(51) Int. Cl.: D06F 34/34, D06F 34/32, D06F 34/30, H03K 17/96, D06F 34/28

(54) **A HOUSEHOLD APPLIANCE COMPRISING TOUCH BUTTON**
HAUSHALTSGERÄT MIT BERÜHRUNGSEMPFINDLICHER TASTE
APPAREIL MÉNAGER COMPRENANT UN BOUTON TACTILE

(30) Priority: 17.11.2020 TR 202018358
(43) Date of publication of application: 25.05.2022
(73) Proprietor: Arçelik Anonim Sirketi, 34445 Istanbul (TR)
(72) Inventor: KARACA, Sema, 34445 Istanbul (TR); YALCIN, Cagdas, 34445 Istanbul (TR); GULDUR, Emir, 34445 Istanbul (TR); CETINKAYA, Bugra, 34445 Istanbul (TR); AKSOY, Gokce, 34445 Istanbul (TR)

(56) References cited:
- EP-A1- 2 773 804
- EP-A1- 2 920 348
- WO-A1-2017/114625

## Description

The present invention relates to a household appliance comprising a touch button provided on the control panel.

In household appliances, touch buttons are preferred to be used on control panels due to their ease of use and aesthetic appearances. The most used of the detection methods for detecting the contact of the user in the touch buttons is detection of the capacitive change by means of springs connected to the circuit board, which have a plate at the ends thereof that contact the control area. One of the most common problems encountered in this type of touch buttons the deformation of the spring fixed to the circuit board in connection errors that occur during the mounting of the circuit board to the control panel or the control panel to the household appliance. In this case, the plate fixed to the spring cannot be aligned with the control area on the control panel, problems such as sensitivity change, wrong key detection occur, and the user cannot control the household appliance as desired by using the control panel. In the state of the art various embodiments are available in order to fix the position of the spring. In one of these embodiments, guides surrounding the spring are placed onto the circuit board. However, this embodiment cannot be utilized when the spring is positioned at a point close to the edge of the circuit board. In another state of the art embodiment, the springs are guided to each other by being surrounded with components assembled thereafter. However, this embodiment is disadvantageous in that the assembly thereof is laborious and time consuming. Another disadvantage of this embodiment is that the buttons get stuck when two components cannot be properly seated or aligned.

The state of the art European Patent Application No. EP2920348 discloses a cover which is mounted to the board holder and which has a first member thereon, and a guide which is attached onto the cover and which has a second member joining with the first member and forming a housing.

In the state of the art European Patent Application No. EP2773804, a two-piece guide is disclosed, which is fixed to the circuit board so as to surround the spring from under the plate.

The aim of the present invention is the realization of a household appliance wherein the control panel with touch button is mounted in a quick and easy manner.

The household appliance realized in order to attain the aim of the present invention, explicated in the first claim and the respective claims thereof, comprises a control panel having a control area designated for the user to touch; a circuit board which is placed on a board holder positioned behind the control panel; a touch button having at least one spring which transmits the capacitive difference that forms by the user touching the designated control area and a conductive plate situated between the control panel and the spring and that is mounted to the upper end of the spring; and a separator which is placed onto the circuit board so as to remain between the circuit board and the control panel.

The household appliance of the present invention comprises a second support which is provided on the board holder and which extends towards the spring such that almost no gap remains between the spring and the second support when the circuit board is attached to the board holder; and a first support which is provided on the edge of the separator facing the spring, which remains at the other side of the spring such that almost no gap remains between the spring and the first support when the separator is placed onto the circuit board and which is positioned opposite to the second support. The spring extends so as to compress and stretch inside the gap between the first support and the second support, which is a little wider than the diameter of the spring. Thus, the first support and the second support bear against the spring during the assembly, preventing the oscillation and bending movement of the spring. Thus, the safety of the spring during the assembly is ensured in a simple manner, and the assembly time is shortened. Another advantage of this embodiment is that cost advantage is provided since no guiding component is used.

In an embodiment of the present invention, the board holder has at least one skirt portion which extends perpendicularly to the circuit board and whereon the edge of the circuit board is seated, and the second support is configured as an extension which is arranged on the skirt and which extends towards the spring. This embodiment is advantageous in that the second support is enabled to be configured depending on the position of the touch button without requiring any change in the geometry of the board. Thus, the length of the second support can be adjusted according to the distance from the touch button to the edge of the board.

In another embodiment of the present invention, the second support has a resting portion which bears against the circuit board, and a guiding portion which extends in the stretching-compressing direction of the spring so as to almost contact the spring. Thus, the second support is enabled to serve in the fixing of the circuit board to the board holder, providing a safer and quicker assembly.

In another embodiment of the present invention, the first support is in the form of a semicircle having a diameter a little larger than the diameter of the spring. Thus, the first support is enabled to support the spring both towards the separator and the sides.

In another embodiment of the present invention, a first protrusion, a second protrusion and a third protrusion are successively positioned at 90-degree arc intervals on the inner portion of the semicircular first support facing the spring, the end portions thereof and the central portion thereof. When the separator is placed onto the circuit board, the second protrusion at the center and the first support are aligned. The production tolerances are balanced by means of the protrusions, and the spring is safely supported from all sides during the assembly.

In another embodiment of the present invention, the first support and the second support have a height smaller than the spring so as to remain under the plate. Thus, the circuit board is enabled to be easily placed onto the board holder and the separator on the circuit board such that the assembly is facilitated.

In another embodiment of the present invention, the plate has a surface wider than the distance between the first support and the second support so as to bear against the first support and the second support from above when the spring is compressed. Thus, the plate is prevented from entering and getting stuck between the first support and the second support, and the compression of the spring is limited when the user applies excessive force onto the control area such that the touch button is prevented from operating erroneously.

In another embodiment of the present invention, the separator has a plurality of housings which surround and enclose a plurality of light sources when the separator is placed onto the circuit board, serving as a reflector, so as to physically separate a plurality of light sources and/or screens provided on the circuit board. This embodiment is advantageous in that ease of placement is provided when the light sources and/or screens are positioned closed to the touch buttons on the circuit board.

In another embodiment of the present invention, the household appliance is a laundry washing machine or a laundry drying machine.

By means of the present invention, connection errors which are caused by the failure to align the touch button with the control area during the assembly are eliminated in a simple manner with any additional costs.

The household appliance realized in order to attain the aim of the present invention is illustrated in the attached figures, where:

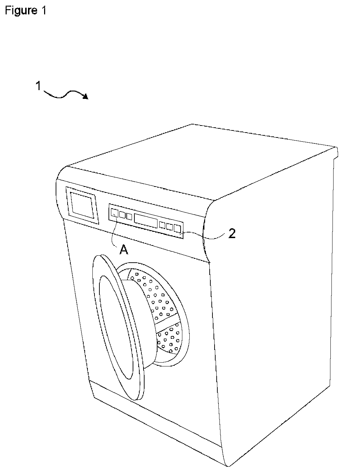

Figure 1- is the perspective view of a household appliance of the present invention.

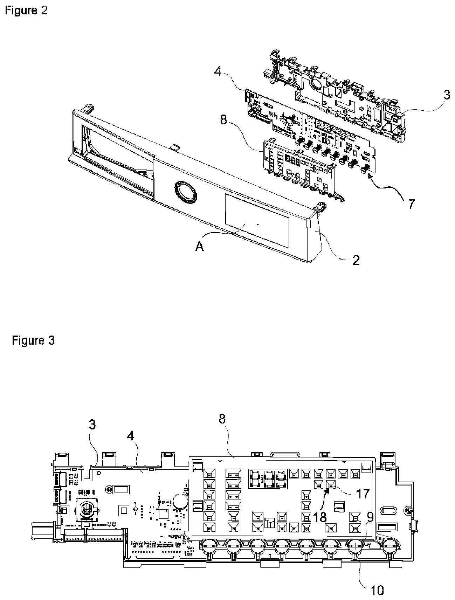

Figure 2 - is the exploded view of the control panel, the separator, the circuit board and the board holder related to an embodiment of the present invention.
Figure 3 - is the assembled view of the control panel, the separator, the circuit board and the board holder related to an embodiment of the present invention.

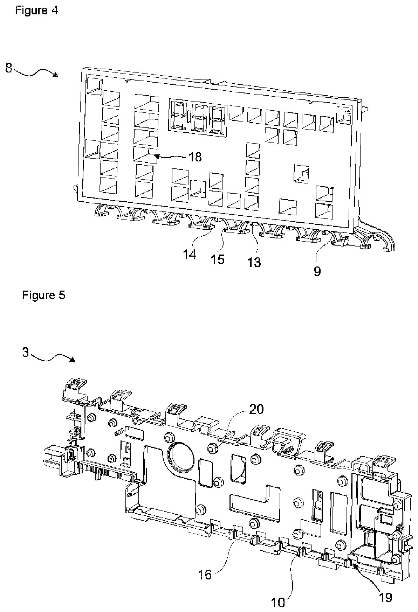

Figure 4 - is the view of the separator related to another embodiment of the present invention.
Figure 5 - is the view of the board holder related to another embodiment of the present invention.

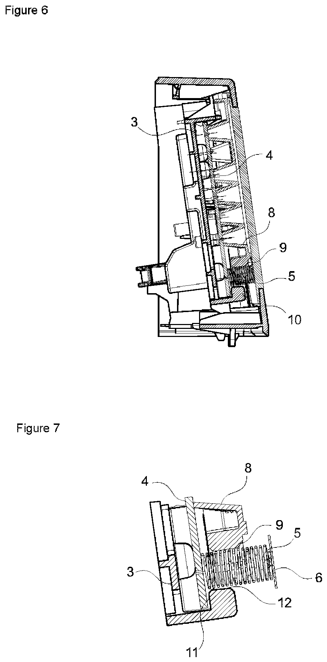

Figure 6 - is the sideways cross-sectional view of the control panel, the separator, the circuit board and the board holder related to an embodiment of the present invention.
Figure 7 - is the sideways partial cross-sectional view of the separator, the circuit board and the board holder related to an embodiment of the present invention.

The elements illustrated in the figures are numbered as follows:
- 1.: Household appliance
- 2.: Control panel
- 3.: Board holder
- 4.: Circuit board
- 5.: Spring
- 6.: Plate
- 7.: Touch button
- 8.: Separator
- 9.: First support
- 10.: Second support
- 11.: Resting portion
- 12.: Guiding portion
- 13.: First protrusion
- 14.: Second protrusion
- 15.: Third protrusion
- 16.: Skirt
- 17.: Light source
- 18.: Housing
- 19.: Slot
- 20.: Embossment

### A: Control area

The household appliance (1) comprises a control panel (2) having a control area (A) thereon which enables the user to select the desired program parameters by touching; a circuit board (4) which is disposed behind the control panel and which is placed onto a board holder (3); at least one touch button (7) having a plate (6) bearing against the control area (A) and at least one spring (5) one end of which is fixed to the plate (6) and the other end to the circuit board (4) and which transmits to the circuit board (4) the capacitive difference forming when the control area (A) is touched; and a separator (8) which is placed onto the circuit board (4) so as to remain between the circuit board (4) and the control panel (2). The end of the spring, which is not connected to the circuit board (4), is connected to the conductive plate (6). When the user moves his/her finger near or touches the control area (A) on the control panel (2) designated for touching, a capacitance is formed between the plate (6) and the point where his/her finger is. The electrical effect generated by the capacitive difference is transmitted to the circuit board (4) designed to detect the capacitance difference by means of the spring (5). The circuit board (4) detects that the button is touched and determines the relevant command entered by the user, and operates the functions of the household appliance (1) depending on these commands.

The household appliance (1) of the present invention comprises at least one first support (9) which is provided on the separator (8) and which is positioned so as to face the spring (5); and at least one second support (10) which is provided on the board holder (3) and which is positioned opposite to the first support (9) such that the spring (5) remains between the first support (9) and the second support (10) almost without any gap. When the circuit board (4) is placed onto the board holder (3), the second support (10) aligns with the the spring (5). Likewise, when the separator (8) is placed onto the board holder (3), the first support (9) aligns with the second support (10) and the spring (5). Thus, the spring (5) is trapped between the first support (9) and the second support (10), and is prevented from moving in directions other than the direction of stretching-compressing. Thus, the spring (5) is provided to remain at the initial position given by the producer.

In an embodiment of the present invention, a skirt (16) extending from one edge of the board holder (3) towards the control panel (2) is provided on the board holder (3), and the second support (10) is arranged on the skirt (16). The board holder (3) comprises a skirt (16) which at least partially surrounds the edge of the circuit board (4) and which extends almost perpendicularly to the circuit board (4), and the second support (10) is arranged on the skirt (16) so as to extend towards the front side of the circuit board (4) whereon the touch button (7) is disposed. Thus, the circuit board (4) can be easily placed onto the board holder (3).

In another embodiment of the present invention, the second support (10) has a resting portion (11) which bears against the front surface of the circuit board (4) facing the control panel (2), and a guiding portion (12) which extends almost parallel to the spring (5). The second support (10) has a resting portion (11) which extends parallel to the front surface of the circuit board (4) whereon the touch button (7) is disposed, and a guiding portion (12) which extends almost perpendicularly to the resting portion (11) in the stretching-compressing direction of the spring (5). In case the second support (10) is arranged on the skirt (16), a slot (19) suitable for receiving the edge of the circuit board (4) is provided between the board holder (3) and the resting portion (11). The circuit board (4) is slidably attached to the board holder (3) such that the edge thereof remains inside the slot (19). In a preferred version of this embodiment, at least one embossment (20), which supports the circuit board (4) from behind towards the resting portion (11), is arranged on the board holder (3). Thus, the circuit board (4) is enabled to be properly seated onto the board holder (3) such that the spring (5) and the second support (10) are always aligned correctly and the assembly errors are eliminated.

In another embodiment of the present invention, the first support (9) is almost in the form of a semicircle. The first support (9) is configured in the form of a semicircle so as to surround one half of the spring (5). The second support (10) is aligned so as to center the first support (9). Thus, the spring (5) is enabled to be supported almost at all sides.

In another embodiment of the present invention, the first support (9) has a first protrusion (13) which is positioned opposite to the second support (10), and a second protrusion (14) and a third protrusion (15) which are opposite to each other on the first support (9). The semicircular first support (9) is suitable for supporting the spring (5) from three directions by means of the second protrusion (14) and the third protrusion (15) provided at two ends thereof and the first protrusion (13) which is positioned at the center thereof so as to be at equal distance to the second protrusion (14) and the third protrusion (15) and aligned with the first support (9). Thus, while being placed onto the circuit board (4), the separator (8) is enabled to be easily aligned with respect to the spring (5) and the board holder (3).

In another embodiment of the present invention, the heights of the first support (9) and the second support (10) are smaller than the free height of the spring (5). Thus, a distance sufficient for the spring (5) to stretch a little remains between the plate (6) and the first support (9) and the second support (10), and when the control panel (2) is seated onto the plate (6), the spring (5) is stretched in the direction of compressing, and the plate (6) is enabled to get into full contact by means of the spring (5) applying pressure to the control panel (2) from below.

In another embodiment of the present invention, the plate (6) has a surface area larger than the diameter of the spring (5) so as to be prevented from entering between the first support (9) and the second support (10). The first support (9) and the second support (10) surround the spring (5) from under the plate (6). Thus, when the spring (5) is compressed during the assembly, the first support (9) and the second support (10) are enabled to support the plate (6) from below, and the touch button (7) is prevented from getting damaged.

In another embodiment of the present invention, a plurality of light sources (17) are provided on the circuit board (4), and the separator (8) has a plurality of housings (18) which surround the light sources (17) so as to separate the light sources (17) from each other. This embodiment is advantageous in that the light sources (17) and the touch buttons (7) are allowed to be positioned close to each other.

In another embodiment of the present invention, the household appliance (1) is a laundry washing machine or a laundry drying machine.

By means of the present invention, the springs (5) are prevented from getting deformed during the assembly in a simple and cost-effective manner.

## Claims

1. A household appliance (1) **comprising** a control panel (2) having a control area (A) thereon which enables the user to select the desired program parameters by touching; a circuit board (4) which is disposed behind the control panel (2) and which is placed onto a board holder (3); at least one touch button (7) having a plate (6) bearing against the control area (A) and at least one spring (5) one end of which is fixed to the plate (6) and the other end to the circuit board (4) and which transmits to the circuit board (4) the capacitive difference forming when the control area (A) is touched; a separator (8) which is placed onto the circuit board (4) so as to remain between the circuit board (4) and the control panel (2), and at least one first support (9) which is provided on the separator (8) and which is positioned on the edge of the separator facing the spring (5); **characterized by** at least one second support (10) which is provided on the board holder (3) and which is positioned opposite to the first support (9) such that the spring (5) remains between the first support (9) and the second support (10) and the spring (5) is trapped between the first support (9) and the second support (10) and is prevented from moving in directions other than the direction of stretching-compressing.

2. A household appliance (1) as in Claim 1, **characterized by** a skirt (16) which is provided on the board holder (3) and which extends from one edge of the board holder (3) towards the control panel (2), and the second support (10) which is arranged on the skirt (16).

3. A household appliance (1) as in Claim 1 or Claim 2, **characterized by** the second support (10) having a resting portion (11) which bears against the front surface of the circuit board (4) facing the control panel (2), and a guiding portion (12) which extends almost parallel to the spring (5).

4. A household appliance (1) as in any one of the above claims, **characterized by** the first support (9) which is almost in the form of a semicircle.

5. A household appliance (1) as in Claim 4, **characterized by** a first protrusion (13) which is positioned on the first support (9) opposite to the second support (10), and a second protrusion (14) and a third protrusion (15) which are opposite to each other on the first support (9).

6. A household appliance (1) as in any one of the above claims, **characterized by** the first support (9) and the second support (10) the heights of which are smaller than the free height of the spring (5).

7. A household appliance (1) as in Claim 6, **characterized by** the plate (6) having a surface area larger than the diameter of the spring (5) so as to be prevented from entering between the first support (9) and the second support (10).

8. A household appliance (1) as in any one of the above claims, **characterized by** a plurality of light sources (17) which are provided on the circuit board (4), and the separator (8) having a plurality of housings (18) which surround the light sources (17) so as to separate the light sources (17) from each other.

9. A household appliance (1) as in any one of Claim 1 to Claim 8, which is a laundry washing machine or a laundry drying machine.

## Patentansprüche

1. Ein Haushaltsgerät (1) umfasst einen Bedienfeld (2) mit einem darauf befindlichen Bedienbereich (A), der es dem Benutzer ermöglicht, durch Berühren die gewünschten Programmparameter auszuwählen; eine Leiterplatte (4), die hinter dem Bedienfeld (2) angeordnet ist und auf einem Platinenhalter (3) platziert ist; mindestens eine Berührungstaste (7) mit einer an der Bedienfläche (A) anliegenden Platte (6) und mindestens einer Feder (5), deren eines Ende an der Platte (6) befestigt ist und das andere Ende mit der Leiterplatte (4) verbunden ist und die kapazitive Differenz, die sich bei Berührung des Bedienbereichs (A) bildet, auf die Leiterplatte (4) überträgt; einen Separator (8), der auf die Leiterplatte (4) aufgesetzt wird, so dass er zwischen der Leiterplatte (4) und dem Bedienfeld (2) verbleibt, und mindestens einen ersten Träger (9), der auf dem Separator vorgesehen ist ( 8) und der an der der Feder (5) zugewandten Kante des Separators positioniert ist; **gekennzeichnet ist es durch** mindestens einen zweiten Träger (10), die am Platinenhalter (3) vorgesehen ist und dem ersten Träger (9) so gegenüberliegt, so dass die Feder (5) zwischen dem ersten Träger (9) und den zweiten Träger (10) verbleibt und die Feder (5) zwischen dem ersten Träger (9) und dem zweiten Träger (10) gefangen ist, und daran gehindert wird, sich in andere Richtungen als die Streck-/Stauchrichtung zu bewegen.

2. Ein Haushaltsgerät (1), wie in Anspruch 1 aufgeführt, **ist dadurch gekennzeichnet, dass** eine Schürze (16), die am Platinenhalter (3) vorgesehen ist und sich von einer Kante des Platinenhalters (3) in Richtung des Bedienfelds (2) erstreckt, und die zweite Stütze (10), die an der Schürze (16) angeordnet ist.

3. Ein Haushaltsgerät (1), wie in Anspruch 1 oder 2 aufgeführt, **ist dadurch gekennzeichnet, dass** der zweite Träger (10) einen Auflageabschnitt (11) aufweist, der an der dem Bedienfeld (2) zugewandten Vorderfläche der Leiterplatte (4) anliegt, und einen Führungsabschnitt (12), der nahezu parallel zur Feder (5) verläuft.

4. Ein Haushaltsgerät (1), wie in einem der vorherigen Ansprüchen aufgeführt, **ist dadurch gekennzeichnet, dass** der erste Träger (9) nahezu die Form eines Halbkreises hat.

5. Ein Haushaltsgerät (1), wie in Anspruch 4 aufgeführt, **ist dadurch gekennzeichnet, dass** ein erster Vorsprung (13), der auf dem ersten Träger (9) gegenüber dem zweiten Träger (10) positioniert ist, und ein zweiter Vorsprung (14) und ein dritter Vorsprung (15), die einander gegenüberliegend auf dem ersten Träger (9) positioniert sind.

6. Ein Haushaltsgerät (1), wie in einem der vorherigen Ansprüchen aufgeführt, **ist dadurch gekennzeichnet, dass** die Höhe des ersten Trägers (9) und dem zweiten Träger (10) kleiner ist als die freie Höhe der Feder (5).

7. Ein Haushaltsgerät (1), wie in Anspruch 6 aufgeführt, **ist dadurch gekennzeichnet, dass** die Platte (6) eine Oberfläche aufweist, die größer als der Durchmesser der Feder (5) ist, so dass sie nicht zwischen den ersten Träger (9) und den zweiten Träger (10) eindringen kann.

8. Ein Haushaltsgerät (1), wie in einem der vorherigen Ansprüchen aufgeführt, **ist dadurch gekennzeichnet, dass** mehrere Lichtquellen (17) auf der Leiterplatte (4) vorgesehen sind und der Separator (8) mehrere Gehäuse (18) aufweist, die die Lichtquellen (17) umgeben, um so die Lichtquellen (17) voneinander zu trennen.

9. Ein Haushaltsgerät (1), wie in den Ansprüchen 1 bis 8 aufgeführt, kann eine Wäschewaschmaschine oder eine Wäschetrocknungsmaschine sein.

## Revendications

1. Un appareil ménager (1) **comprenant** un panneau de commande (2) comportant une zone de commande (A) qui permet à l'utilisateur de sélectionner les paramètres de programme souhaités en les touchant ; une carte de circuit imprimé (4) disposée derrière le panneau de commande (2) et placée sur un support de carte (3) ; au moins un bouton tactile (7) comportant une plaque (6) en appui sur la zone de commande (A) et au moins un ressort (5) dont une extrémité est fixée à la plaque (6) et l'autre à la carte de circuit imprimé (4) et qui transmet à la carte de circuit imprimé (4) la différence capacitive qui se forme lorsque la zone de commande (A) est touchée ; un séparateur (8) qui est placé sur la carte de circuit imprimé (4) de manière à rester entre la carte de circuit imprimé (4) et le panneau de commande (2), et au moins un premier support (9) qui est prévu sur le séparateur (8) et qui est positionné sur le bord du séparateur en face du ressort (5) ; **caractérisé par** au moins un second support (10) qui est prévu sur le support de carte (3) et qui est positionné à l'opposé du premier support (9) de sorte que le ressort (5) reste entre le premier support (9) et le second support (10) et que le ressort (5) soit coincé entre le premier support (9) et le second support (10) et soit empêché de se déplacer dans des directions autres que la direction de l'étirement-compression.

2. Un appareil ménager (1) tel que dans la déclaration 1, **caractérisé par** une jupe (16) qui est prévue sur le support de planche (3) et qui s'étend d'un bord du support de planche (3) vers le panneau de commande (2), et le deuxième support (10) qui est disposé sur la jupe (16).

3. Un appareil ménager (1) tel que dans la déclaration 1 ou la déclaration 2, **caractérisé par le fait que** le deuxième support (10) a une partie de repos (11) qui s'appuie contre la surface avant de la carte de circuit imprimé (4) faisant face au panneau de commande (2), et une partie de guidage (12) qui s'étend presque parallèlement au ressort (5).

4. Un appareil ménager (1) selon l'une quelconque des déclarations précédentes, **caractérisé par** le premier support (9) qui a presque la forme d'un demi-cercle.

5. Un appareil ménager (1) selon la déclaration 4, **caractérisé par** une première protubérance (13) qui est positionnée sur le premier support (9) à l'opposé du deuxième support (10), et une deuxième protubérance (14) et une troisième protubérance (15) qui sont opposées l'une à l'autre sur le premier support (9).

6. Un appareil ménager (1) selon l'une quelconque des déclarations précédentes, **caractérisé par** le premier support (9) et le second support (10) dont les hauteurs sont inférieures à la hauteur libre du ressort (5).

7. Un appareil ménager (1) selon la déclaration 6, **caractérisé par le fait que** la plaque (6) présente une surface plus grande que le diamètre du ressort (5) de manière à être empêchée de pénétrer entre le premier support (9) et le second support (10).

8. Un appareil ménager (1) tel que dans l'une quelconque des déclarations précédentes, **caractérisé par** une pluralité de sources lumineuses (17) qui sont prévues sur la carte de circuit imprimé (4), et le séparateur (8) ayant une pluralité de boîtiers (18) qui entourent les sources lumineuses (17) de manière à séparer les sources lumineuses (17) l'une de l'autre.

9. Un appareil ménager (1) selon l'une quelconque des déclarations 1 à 8, qui est une machine à laver le linge ou une machine à sécher le linge.
